# EUROPÄISCHE PATENTSCHRIFT

(11) **EP 3 332 235 B1**
(45) Veröffentlichungstag und Bekanntmachung des Hinweises auf die Patenterteilung: **11.03.2020**
(21) Anmeldenummer: 16751545.1
(22) Anmeldetag: 04.08.2016
(51) Int. Cl.: G01L 3/14, G01L 5/16, B25J 13/08, G01L 5/22, G01L 1/22, H05K 3/32, H05K 1/02, H05K 1/14

(54) **KRAFT-MOMENT-SENSOR UND PLATINENANORDNUNG FÜR EINEN DERARTIGEN KRAFT-MOMENT-SENSOR**
FORCE-TORQUE SENSOR AND PRINTED CIRCUIT BOARD ARRANGEMENT FOR SUCH A FORCE-TORQUE SENSOR
CAPTEUR DE FORCE-COUPLE ET ENSEMBLE DE PLATINES POUR UN CAPTEUR FORCE-COUPLE DE CE TYPE

(30) Priorität: 07.08.2015 DE 102015215099
(43) Veröffentlichungstag der Anmeldung: 13.06.2018
(73) Patentinhaber: Dr. Doll Engineering GmbH, 74193 Schwaigern (DE)
(72) Erfinder: DOLL, Theo, 74193 Schwaigern (DE)
(74) Vertreter: Patentanwälte Ruff, Wilhelm, Beier, Dauster & Partner mbB
(86) Internationale Anmeldenummer: PCT/EP2016/068642
(87) Internationale Veröffentlichungsnummer: WO 2017/025428

(56) Entgegenhaltungen:
- EP-A1- 1 445 596
- EP-A2- 0 261 071
- DE-A1- 10 217 018
- DE-A1-102007 017 862
- JP-A- H02 268 237
- US-A- 4 478 089
- US-A- 4 763 531
- US-A- 4 928 206
- US-A- 5 063 788
- US-A1- 2003 150 276
- DWARAKANATH T A ET AL: "Beam type hexapod structure based six component forcetorque sensor", MECHATRONICS, PERGAMON PRESS, OXFORD, GB, Bd. 21, Nr. 8, 14. August 2011 (2011-08-14), Seiten 1279-1287, XP028121653, ISSN: 0957-4158, DOI: 10.1016/J.MECHATRONICS.2011.08.004 [gefunden am 2011-08-20]

## Beschreibung

Die Erfindung betrifft einen Kraft-Moment-Sensor zur Erfassung von Kräften und Momenten bei einer Robotikeinheit mit einem einteiligen Trägerkörper, der eine zylindrische Grundform aufweist und mit zwei zueinander parallelen Anschlussscheiben sowie wenigstens drei die Anschlussscheiben miteinander verbindenden Brückenelementen versehen ist, denen jeweils wenigstens eine Messstelle zugeordnet ist.

Die Erfindung betrifft zudem eine Platinenanordnung als Teil eines derartigen Kraft-Moment-Sensors mit wenigstens einer Elektronikplatine, auf der Elektronikkomponenten angeordnet sind, sowie mit wenigstens einer Anschlussplatine, die mit der wenigstens einen Elektronikplatine über Leitungen verbunden ist.

Aus der DE 102 17 018 A1 ist ein Kraft-Moment-Sensor bekannt, der eine zylindrische Grundform aufweist. Der Kraft-Moment-Sensor ist mit einem monolithischen Trägerkörper versehen, der zwei zueinander parallele Anschlussscheiben aufweist. Die Anschlussscheiben sind über insgesamt sechs Brückenelemente miteinander verbunden, die als paarweise zueinander ausgerichtete Stäbe gestaltet sind. Jeweils zwei Stäbe sind V-artig relativ zueinander ausgerichtet und einteilig zwischen den Anschlussscheiben erstreckt.

Ein weiterer Kraft-Moment-Sensor ist aus der JP 2268237 A bekannt. Auch dort weist der Kraft-Moment-Sensor einen monolithischen Trägerkörper mit zwei zueinander parallelen, Zylinderring-förmigen Anschlussscheiben auf, die untereinander über oktogonal gestaltete Brückenelemente miteinander verbunden sind. Den Brückenelementen sind Dehnmessstreifen zugeordnet. Die Dehnmessstreifen sind über eine geeignete Elektronik verschaltet.

Die US 4 928 206 betrifft einen Isolierbehälter, in dem aufrecht stehend mehrere Elektronikplatinen angeordnet sind. Der Isolierbehälter wird mit einem geeigneten Kühlmittel aufgefüllt.Die GB 962 082 A offenbart einen Kraftsensor, der einen zylindrischen Stab aufweist. Der Stab ist zur Erhöhung des Messeffektes mit zylindrischen Bohrungen und mit konkaven Einbuchtungen versehen. Die Bohrungen und Einbuchtungen weisen Dehnungsmessstreifen auf und fungieren als Messstellen des Kraftsensors.

Ein Kraft-Moment-Sensor ist aus der EP 0 261 071 A2 bekannt. Der Kraft-Moment-Sensor dient dazu, Kräfte und/oder Momente in einer Vielzahl von wechselweise zueinander orthogonalen Richtungen zwischen einem Antriebselement und einem Abtriebselement zu erfassen. Der Kraft-Moment-Sensor weist einen einteiligen Trägerkörper auf, der an gegenüberliegenden Seiten mit zwei zylindrischen Anschlussscheiben versehen ist. Der Kraft-Moment-Sensor ist für den Einsatz bei einer Robotikeinheit vorgesehen. Die Anschlussscheiben dienen dazu, mit entsprechenden Elementen der Robotikeinheit verbunden zu werden. Die beiden zylindrischen Scheiben sind über polygonale Brückenelemente miteinander verbunden, die im Bereich der Außenränder der Anschlussscheiben positioniert sind und sich in Hochrichtung zwischen den Anschlussscheiben erstrecken. Die Brückenelemente sind gleichmäßig über den Umfang des Trägerkörpers verteilt und gehen einstückig in die beiden Anschlussscheiben über. Jedes Brückenelement weist eine zentrale zylindrische Bohrung auf, die jeweils eine Messstelle des Kraft-Moment-Sensors definiert. In der zentralen zylindrischen Bohrung sind Dehnmessstreifen vorgesehen, die über entsprechende Verdrahtungen mit Elektrik- und Elektronikkomponenten verbunden sind.

Die Dehnmessstreifen werden bei einer praktischen Ausführung des Kraft-Moment-Sensors von Hand einzeln an die entsprechenden Messstellen aufgebracht und mit entsprechenden Elektrik- und Elektronikkomponenten verdrahtet.

Aufgabe der Erfindung ist es, einen Kraft-Moment-Sensor, eine Platinenanordnung und ein Dehnmessstreifen-System der eingangs genannten Art zu schaffen, die eine verbesserte Genauigkeit bei der Erfassung von Kräften und Momenten ermöglichen.

Die der Erfindung zugrundeliegende Aufgabe wird bei einem Kraft-Moment-Sensor dadurch gelöst, dass der Trägerkörper im Bereich wenigstens einer Anschlussscheibe auf einer der anderen Anschlussscheibe zugewandten Innenseite mit einer Stützanordnung versehen ist, an der wenigstens eine mit Elektronikkomponenten versehene Platinenanordnung hochkant ausgerichtet fixiert ist. Die Stützanordnung kann durch wenigstens einen Stützwinkel, durch wenigstens einen Stützschlitz zur Steckaufnahme der Platinenanordnung, durch einen Stützblock oder Ähnliches ausgeführt sein. Wesentlich für die Stützanordnung ist es, dass die plattenförmige Plattenanordnung in hochkanter Ausrichtung zwischen den Anschlussscheiben positioniert und gestützt ist. Die Stützanordnung kann einstückig an der Anschlussscheibe vorgesehen sein, oder als wenigstens ein separates Bauteil hergestellt sein, das mit der inneren Stirnfläche der Anschlussscheibe lösbar oder unlösbar verbunden ist. Der Stützblock kann stegförmig oder als massiver Block einstückig am Trägerkörper ausgeformt sein. Die Stützanordnung weist vorzugsweise eine orthogonal zu einer Stirnfläche der jeweiligen Anschlussscheibe ausgerichtete Anlagefläche für die Platinenanordnung auf. Die Stützanordnung kann auch mehrere, über den Umfang des Trägerkörpers verteilt angeordnete Anlageflächen oder Stützflächen für mehrere Platinenanordnungen aufweisen. Die aufrecht stehende, d. h. hochkante Ausrichtung der Platinenanordnung orthogonal zu entsprechenden Grund- bzw. Stirnflächen der Anschlussscheiben gewährleistet eine platzsparende Unterbringung der wenigstens einen Platinenanordnung. Hierdurch ergibt sich genügend Raum für die Führung von Verdrahtungen oder Verkabelungen oder für unterschiedliche Bohrbilder im Bereich der Anschlussscheiben zur Befestigung an unterschiedlichen Robotikkomponenten.

In Ausgestaltung der Erfindung weist jedes Brückenelement eine zentrale zylindrische Bohrung als Messstelle auf und ist an seinen gegenüberliegenden Außenrändern mit jeweils einer konkaven Einbuchtung versehen, an der jeweils eine weitere Messstelle vorgesehen ist. Durch die konkaven Einbuchtungen wird die Anzahl der Messstellen bei dem Kraft-Moment-Sensor erhöht, wodurch sich eine höhere Genauigkeit für die Erfassung von Kräften und Momenten bei einer Robotikeinheit erzielen lässt.

In weiterer Ausgestaltung der Erfindung ist jede konkave Einbuchtung teilzylindrisch gestaltet, wobei alle Einbuchtungen jeweils den gleichen Radius aufweisen. Auch alle zentralen zylindrischen Bohrungen der Brückenelemente weisen jeweils den gleichen Radius auf, wobei sich dieser Radius von den Radien der Einbuchtungen unterscheiden kann. In vorteilhafter Weise bleiben die Abmessungen der zentralen zylindrischen Bohrungen der Brückenelemente sowie der konkaven Einbuchtungen unabhängig von der Baugröße des jeweiligen Kraft-Moment-Sensors identisch.

In weiterer Ausgestaltung der Erfindung ist die Platinenanordnung in ihrer Höhe auf einen Abstand der Anschlussscheiben des Trägerkörpers abgestimmt. Die Platinenanordnung kann daher den zur Verfügung stehenden Bauraum zwischen den Anschlussscheiben ausnutzen. Die hochkante Ausrichtung entspricht der aufrecht stehenden Ausrichtung. Die Platinenanordnung kann zu wenigstens einer Innenfläche einer Anschlussscheibe beabstandet oder mit beiden Innenflächen der beiden Anschlussscheiben in Berührungskontakt stehen. Die Platinenanordnung kann auch an zwei Stützanordnungen der gegenüberliegenden Anschlussscheibe oben und unten befestigt sein. Eine Höhe und eine Länge der Platinenanordnungen ist vorzugsweise auf eine kleinste Baugröße von Kraft-Moment-Sensoren abgestimmt. Bei entsprechend größeren Kraft-Moment-Sensoren sind identische Platinenanordnungen einsetzbar, die im Verhältnis zu den Funktionsteilen eines größeren Kraft-Moment-Sensors dann innerhalb des Sensors weniger Bauraum benötigen.

Dies ermöglicht eine Bauteil- und Kostenreduzierung, da immer gleiche, vorgefertigte Platinenanordnungen für Kraft-Moment-Sensoren unterschiedlicher Baugrößen eingesetzt werden können.

In weiterer Ausgestaltung der Erfindung sind die Brückenelemente als Hexapod-Streben gestaltet. Diese Ausgestaltung ist vorgesehen, wenn der Kraft-Moment-Sensor nach dem Hexapod-Prinzip ausgeführt ist. Dabei sind zwischen den Anschlussscheiben mehrere schräg verlaufende Streben vorgesehen, denen die Messstellen zugeordnet sind. Diese Streben sind vorzugsweise einstückig mit den Anschlussscheiben und werden auch als Hexapod-Streben bezeichnet.

In weiterer Ausgestaltung der Erfindung sind an den Messstellen Dehnmessstreifen vorgesehen, die jeweils in vorgefertigter Anordnung und Gruppierung auf einer Trägerfolie gehalten sind, die im Bereich der Messstellen mit dem jeweiligen Brückenelement verklebt ist. Die Anordnung und Gruppierung der Dehnmessstreifen auf einer Trägerfolie ermöglicht eine Vorfertigung der Trägerfolie, wodurch sich ein vorgefertigtes Dehnmessstreifen-System ergibt, das lediglich noch in einfacher Weise im Bereich der entsprechenden Messstelle auf das Brückenelement aufgebracht werden muss. Neben der Möglichkeit einer exakten Ausrichtung der Dehnmessstreifen auf der Trägerfolie ergibt sich auch eine kompakte und platzsparende Anordnung. Zudem ist hierdurch eine Vollbrückenschaltung der Dehnmessstreifen erzielbar, die gegenüber einer Halbbrückenschaltung wesentlich höhere Messamplituden erzeugt.

Für die Platinenanordnung wird die der Erfindung zugrundeliegende Aufgabe dadurch gelöst, dass wenigstens zwei Elektronikplatinen miteinander und/oder wenigstens eine Anschlussplatine mit wenigstens einer Elektronikplatine über wenigstens ein flexibles Verbindungselement verbunden sind, in dem die Leitungen integriert sind. Hierdurch ergibt sich eine variabel ausrichtbare Platinenanordnung, die für eine Fixierung an unterschiedliche Baugrößen oder Gestaltungen von Kraft-Moment-Sensoren angepasst werden kann. Dadurch, dass entsprechende elektronische oder elektrische Leitungen in dem wenigstens einen flexiblen Verbindungselement integriert sind, kann die Platinenanordnung vollständig vorgefertigt für eine Montage an dem entsprechenden Kraft-Moment-Sensor angeliefert werden.

In Ausgestaltung der Platinenanordnung erstreckt das wenigstens eine flexible Verbindungselement sich durchgängig über eine gesamte Höhe einer benachbarten Elektronikplatine. Das wenigstens eine flexible Verbindungselement definiert eine Biege- oder Knickstelle nach Art eines Festkörpergelenks. In weiterer Ausgestaltung erstreckt das wenigstens eine flexible Verbindungselement sich durchgängig längs eines Seitenrands einer Anschlussplatine. Demzufolge ist eine entsprechende Anschlussplatine relativ zu der benachbarten Elektronikplatine biegbar und Elektronikplatinen sind relativ zueinander beweglich. Die Elektronikplatinen sowie die Anschlussplatinen selbst sind formstabil ausgeführt.

In weiterer Ausgestaltung der Erfindung ist das flexible Verbindungselement derart biegbar, dass die Elektronikplatine und die wenigstens eine Anschlussplatine einander parallel überlappend zusammenfaltbar sind. Hierdurch ist eine platzsparende Anordnung von Platinenanordnungen innerhalb eines Kraft-Moment-Sensors oder innerhalb eines Steckverbindungsteiles eines Kraft-Moment-Sensors ermöglicht.

Weitere Vorteile und Merkmale der Erfindung ergeben sich aus den Ansprüchen sowie aus der nachfolgenden Beschreibung bevorzugter Ausführungsbeispiele, die anhand der Zeichnungen dargestellt sind.
- Fig. 1: zeigt in perspektivischer Darstellung einen einstückigen Trägerkörper einer Ausführungsform eines erfindungsgemäßen Kraft-Moment-Sensors,
- Fig. 2: den Trägerkörper nach Fig. 1 in anderer Perspektive,
- Fig. 3: eine Seitenansicht der Ausführungsform des erfindungsgemäßen Kraft-Moment-Sensors mit einem Trägerkörper nach den Fig. 1 und 2,
- Fig. 4: eine Schnittdarstellung durch den Kraft-Moment-Sensor entlang der Schnittlinie IV-IV in Fig. 3,
- Fig. 5: in vergrößerter, perspektivischer und ausgeschnittener Darstellung ein Brückenelement des Trägerkörpers nach den Fig. 1 und 2 mit aufgebrachten Dehnmessstreifen-Systemen,
- Fig. 6: in vergrößerter schematischer Darstellung eine Ausführungsform eines Dehnmessstreifen-Systems, wie es bei dem Kraft-Moment-Sensor nach den Fig. 3 und 4 eingesetzt ist,
- Fig. 7: in vergrößerter Darstellung eine weitere Ausführungsform eines erfindungsgemäßen Dehnmessstreifen-Systems, wie es bei dem Kraft-Moment-Sensor nach den Fig. 3 und 4 eingesetzt ist,
- Fig. 8: eine Frontansicht einer Ausführungsform einer erfindungsgemäßen Platinenanordnung, wie sie bei dem Kraft-Moment-Sensor nach den Fig. 3 und 4 eingesetzt ist,
- Fig. 9: eine Draufsicht auf die Platinenanordnung nach Fig. 8,
- Fig. 10: eine Seitenansicht der Platinenanordnung nach den Fig. 8 und 9,
- Fig. 11: schematisch einen zusammengefalteten Zustand der Platinenanordnung nach den Fig. 8 bis 10,
- Fig. 12: eine weitere Ausführungsform eines erfindungsgemäßen Kraft-Moment-Sensors ähnlich den Figuren 1 bis 11,
- Fig. 13: eine Ansicht von unten des Kraft-Moment-Sensors nach Figur 12,
- Fig. 14: in einer Seitenansicht eine weitere Ausführungsform eines erfindungsgemäßen Kraft-Moment-Sensors in Hexapod-Ausführung,
- Fig. 15: einen Schnitt durch den Kraft-Moment-Sensor nach Fig. 14 entlang der Schnittlinie XV in Fig. 14,
- Fig. 16: eine weitere Seitenansicht des Kraft-Moment-Sensors nach den Figuren 14 und 15,
- Fig. 17a und 17b: in einer Seitenansicht und einer Schnittdarstellung eine weitere Ausführungsform eines erfindungsgemäßen Kraft-Moment-Sensors,
- Fig. 18a und 18b: in einer Seitenansicht und einer Schnittdarstellung eine weitere Ausführungsform eines erfindungsgemäßen Kraft-Moment-Sensors und
- Fig. 19a und 19b: in einer Seitenansicht und einer Schnittdarstellung eine letzte Ausführungsform eines erfindungsgemäßen Kraft-Moment-Sensors.

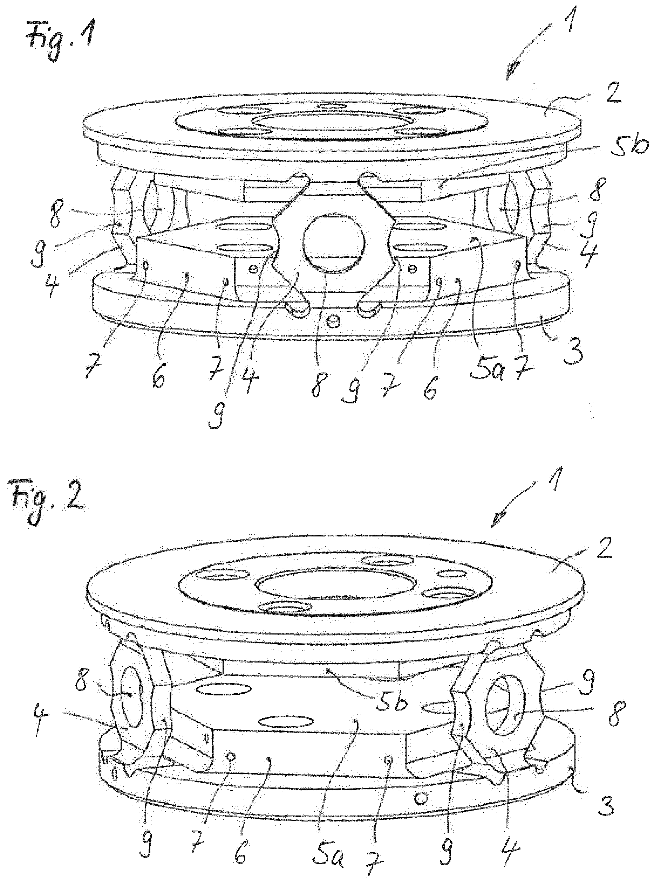

Ein Kraft-Moment-Sensor nach den Fig. 1 bis 4 ist dazu vorgesehen, Kräfte und Momente zwischen verschiedenen Teilen einer Robotikeinheit zu erfassen, um Beschädigungen oder Überlastungen der Robotikeinheit vermeiden zu können. Der Kraft-Moment-Sensor weist einen Trägerkörper 1 auf, der einstückig und massiv aus Metall hergestellt ist. Der Trägerkörper 1 wird durch spanende Bearbeitung aus einem massiven Metallblock geschaffen. Der Trägerkörper 1 weist zwei parallel zueinander beabstandete, im Wesentlichen zylindrische Anschlussscheiben 2 auf, die jeweils mit Anschlussgeometrien zur Verbindung mit einer entsprechenden Robotickomponente versehen sind. Die beiden Anschlussscheiben 2, 3 sind über drei Brückenelemente 4 miteinander verbunden, die sich in Hochrichtung zwischen entsprechenden Randbereichen der Anschlussscheiben 2, 3 erstrecken, und die gleichmäßig über einen Umfang des Trägerkörpers 1 verteilt angeordnet sind. Jedes Brückenelement 4 ist als polygonales Plattenelement ausgeführt. Jedes Brückenelement 4 ist zudem mit einer zentralen, zylindrischen Bohrung 8 versehen, die radial zu einer in Hochrichtung erstreckten Mittellängsachse des Trägerkörpers 1 ausgerichtet sind. Jedes Brückenelement 4 weist zudem an gegenüberliegenden Seitenrändern jeweils eine konkave Einbuchtung 9 auf. Die konkaven Einbuchtungen 9 sind teilzylindrisch gestaltet und weisen zueinander identische Radien auf. Die Radien der Einbuchtungen 9 sind größer als die Radien der zentralen zylindrischen Bohrungen 8. Entsprechende Mittelpunkte aller zentraler zylindrischer Bohrungen 8 wie auch Mittelpunkte der kreisbogenförmigen bzw. teilzylindrischen Krümmungen der Einbuchtungen 9 aller Brückenelemente 4 liegen in einer gemeinsamen Mittelradialebene relativ zu der Mittellängsachse des Trägerkörpers 1.

Jede Anschlussscheibe 2, 3 ist zudem innenseitig mit einem zur jeweils anderen Anschlussscheibe 2, 3 hin gewandten Stützblock 5a, 5b versehen. Beide Stützblöcke 5a, 5b sind in ihrer Grundfläche sechseckig ausgeführt. Beide Stützblöcke 5a, 5b weisen orthogonal zur jeweiligen Innenfläche der jeweiligen Anschlussscheibe 2, 3 abragende, ebene Stützflächen 6 auf. Die Stützflächen 6 des unteren Stützblocks 5a sind zudem mit Befestigungsmitteln in Form von Gewindebohrungen 7 versehen, auf die nachfolgend näher eingegangen wird. Auch die beiden Stützblöcke 5a, 5b sind einstückige Teilbereiche des Trägerkörpers 1. Die Anschlussscheiben 2, 3 sowie die Stützblöcke 5a, 5 weisen Durchtritte für Kabel- und Leitungsführungen auf.

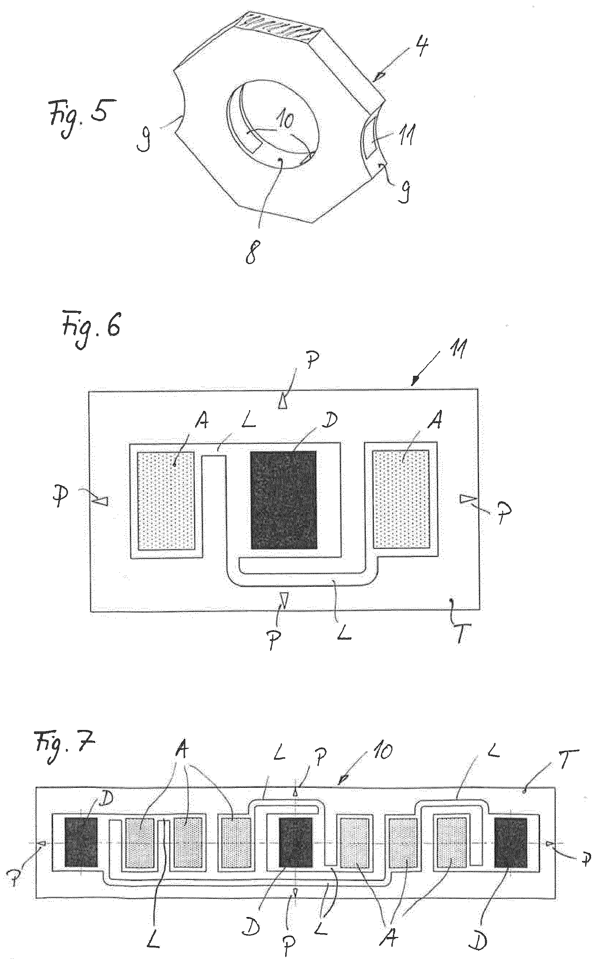

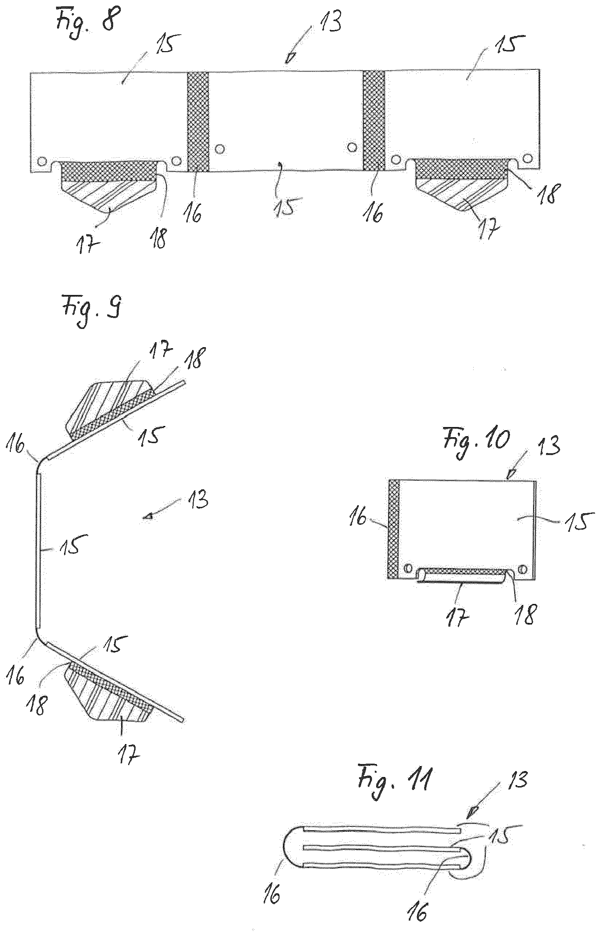

Jedes Brückenelement 4 bildet im Bereich der jeweiligen zentralen zylindrischen Bohrung 8 sowie im Bereich der einander an jedem Brückenelement 4 paarweise gegenüberliegenden konkaven Einbuchtungen 9 Messstellen, denen Dehnmessstreifen-Systeme 10, 11 zugeordnet sind. Im Bereich einer Innenseite jeder zentralen zylindrischen Bohrung 8 sind jeweils zwei Dehnmessstreifen-Systeme 10 angebracht, wohingegen im Bereich jeder Einbuchtung 9 jeweils ein Dehnmessstreifen-System 11 aufgebracht ist. Jedes Dehnmessstreifen-System 10, 11 ist mittels lediglich schematisch strichpunktiert dargestellter Verdrahtungen 12 mit einer Platinenanordnung 13 elektrisch verbunden, die anhand der Fig. 8 bis 11 dargestellt ist. Die Dehnmessstreifen-Systeme 10 und 11 sind anhand der Fig. 6 und 7 näher dargestellt.

Das Dehnmessstreifen-System 11 gemäß Fig. 6 besteht aus einem einzelnen Dehnmessstreifen D sowie aus zwei Anschlussflächen A, die über Leiterbahnen L mit dem Dehnmessstreifen D verbunden sind. Der Dehnmessstreifen D sowie die als Lötanschlussflächen gestalteten Anschlussflächen A sind auf einer Trägerfolie T aufgebracht, die flexibel gestaltet ist und auf ihrer Unterseite mit einer Klebstoffschicht versehen ist. Die Trägerfolie T ist auf die Abmessungen der jeweiligen konkaven Einbuchtung 9 abgestimmt, um vollflächig auf eine Oberfläche der konkaven Einbuchtung aufgebracht werden zu können. Die Trägerfolie T ist in der Draufsicht rechteckig ausgeführt. Sowohl der Dehnmessstreifen D als auch die Anschlussflächen A sind mit ihren Randflächen exakt parallel zu entsprechenden Seitenrändern der Trägerfolie T sowie mittig ausgerichtet zu der Trägerfolie T aufgebracht. Die Trägerfolie T weist Positionsmarkierungen P auf, um eine exakte Ausrichtung der Trägerfolie T auf der Oberfläche der entsprechenden Einbuchtung 9 zu ermöglichen.

Das Dehnmessstreifen-System 10 nach Fig. 7 weist ebenfalls eine Trägerfolie T auf, die eine größere Länge besitzt als die Trägerfolie T des Dehnmessstreifen-Systems 11. Auf der Trägerfolie T gemäß Fig. 7 sind insgesamt drei Dehnmessstreifen D und sechs Anschlussflächen 6A untergebracht, die über Leiterbahnen L miteinander und mit den Dehnmessstreifen D verbunden sind. Anhand der Fig. 7 ist auch erkennbar, dass die Dehnmessstreifen D über die Leiterbahnen L auch miteinander zu einer Brückenschaltung vorverdrahtet sind. Sowohl die Leiterbahnen L als auch die Anschlussflächen A und die Dehnmessstreifen D sind flächig auf der flexiblen Trägerfolie T aufgebracht. Die Anschlussflächen A des Dehnmessstreifen-Systems 10 nach Fig. 7 sind in gleicher Weise als Lötanschlussflächen ausgeführt wie die Anschlussflächen A gemäß Fig. 6.

Zwei solcher Dehnmessstreifen-Systeme 10 werden auf die Innenfläche der zentralen zylindrischen Bohrung 8 einander exakt spiegelsymmetrisch gegenüberliegend aufgebracht, wie anhand der Fig. 5 erkennbar ist. Die Fig. 5 stellt ein freigeschnittenes Brückenelement 4 dar.

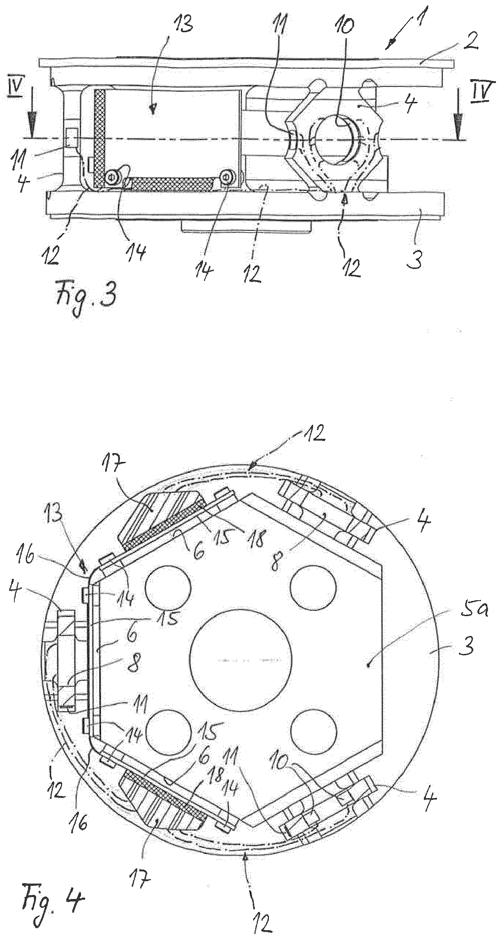

Die Verdrahtungen 12 werden mit den beschriebenen Anschlussflächen A durch Verlöten verbunden. Mit ihren gegenüberliegenden Endbereichen sind die Verdrahtungen 12 in nachfolgend näher beschriebener Weise an die Platinenanordnung 13 elektrisch leitend angebunden. Die Platinenanordnung 13 dient zur Verstärkung von Messsignalen der Dehnmessstreifen-Systeme 10 und 11. Die Platinenanordnung 13 gemäß den Fig. 3, 4 und 8 bis 11 weist drei formstabile Elektronikplatinen 15 auf, auf denen entsprechende Elektronikkomponenten aufgebracht sind, die benötigt werden, um die gewünschte Messverstärkung zu erzielen. Die drei Elektronikplatinen 15 sind über flexible Verbindungselemente 16 miteinander verbunden, die als flexible Verbindungsstreifen ausgeführt sind. Die Verbindungselemente 16 verbinden benachbarte Randbereiche der Elektronikplatinen 15 miteinander. Zudem sind in den flexiblen Verbindungselementen 16 elektrische Leitungen integriert, die die benachbarten Elektronikplatinen 15 elektrisch miteinander verbinden.

Die Platinenanordnung 13 weist zudem zwei formstabile Anschlussplatinen 17 auf, die bei der Ausführungsform nach den Fig. 8 bis 10 dreieckförmig gestaltet sind, wohingegen die Elektronikplatinen 15 im Wesentlichen rechteckig ausgeführt sind. Jede Anschlussplatine 17 ist über ein weiteres flexibles Verbindungselement 18 mit der zugehörigen Elektronikplatine 15 verbunden. Die flexiblen Verbindungselemente 18 sind wie die flexiblen Verbindungselemente 16 laschenförmig ausgeführt. Auch in den Verbindungselementen 18 sind elektrische Leitungen integriert, die die Anschlussplatine 17 mit den Elektronikkomponenten der jeweiligen Elektronikplatine 15 elektrisch verbinden. Die jeweilige Anschlussplatine 17 ist mit elektrischen Anschlussstellen versehen, mit denen die Verdrahtungen 12 in geeigneter Weise, insbesondere durch Verlöten, elektrisch verbunden werden. Die Zuordnung der Verdrahtungen 12 zu den beiden Anschlussplatinen 17 ist anhand der Fig. 4 schematisch dargestellt. Dabei ist erkennbar, dass die Messstellen von zwei Brückenelementen 4 mit der einen Anschlussplatine 17 verbunden werden, wohingegen die Messstellen des dritten Brückenelements 4 mit der anderen Anschlussplatine 17 verbunden sind. Die jeweilige Platinenanordnung 13 wird mit Hilfe von mechanischen Befestigungselementen in Form von Befestigungsschrauben 14 an der entsprechenden ebenen Stützfläche 6 des jeweiligen Stützblockes 5a, 5b in hochkanter Ausrichtung befestigt, wobei die Befestigungsschrauben 14 in die Gewindebohrungen 7 eingeschraubt werden.

Anhand der Fig. 11 ist erkennbar, dass die Flexibilität der laschenförmigen Verbindungselemente 16 so gestaltet ist, dass die Elektronikplatinen 15 parallel aufeinandergefaltet werden können, um so eine kompakte Lagerung der Platinenanordnung 13 zu ermöglichen. Durch die Flexibilität der Ausrichtung der Platinenanordnung 13 ist eine Anpassung der Platinenanordnung 13 an unterschiedliche Baugrößen und Gestaltungen von Kraft-Moment-Sensoren gewährleistet.

Erfindungsgemäß sind Kraft-Moment-Sensoren gemäß den Fig. 3 und 4 in unterschiedlichen Baugrößen herstellbar. Bei allen derartigen Kraft-Moment-Sensoren unterschiedlicher Baugrößen bleiben jedoch die Durchmesser der zentralen zylindrischen Bohrungen 8 sowie die Radien der konkaven Einbuchtungen 9 identisch zueinander, so dass entsprechende Dehnmessstreifen-Systeme 10, 11 nicht für jede Baugröße neu konfektioniert werden müssen, sondern vielmehr gleiche Dehnmessstreifen-Systeme 10, 11 für die unterschiedlichen Baugrößen von Kraft-Moment-Sensoren eingesetzt werden können. Die Dicke der Brückenelemente und die Abstände der Mittelpunkte der Radien der Bohrungen und der benachbarten Einbuchtungen sind variabel abhängig von der Sensorbaugröße. Dies beeinflusst den Einsatz gleicher Dehnmesssysteme nicht.

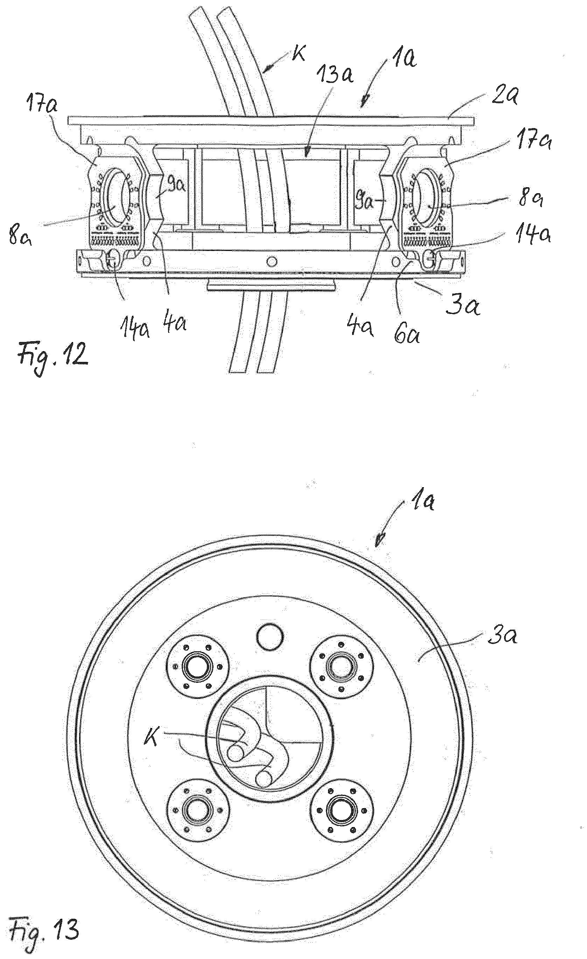

Der Kraft-Moment-Sensor 1a gemäß den Figuren 12 und 13 entspricht im Wesentlichen dem zuvor beschriebenen Ausführungsbeispiel. Zur Vermeidung von Wiederholungen wird daher ergänzend auf die zuvor beschriebene Ausführungsform verwiesen. Funktionsgleiche Bauteile oder Abschnitte sind mit gleichen Bezugszeichen unter Hinzufügung des Buchstabens a versehen. Der Kraft-Moment-Sensor 1a weist eine obere Anschlussscheibe 2a und eine untere Anschlussscheibe 3a auf, die über mehrere Brückenelemente 4a einstückig miteinander verbunden sind. Wesentlicher Unterschied zu der Ausführungsform gemäß den Figuren 1 bis 11 ist es, dass entsprechende Anschlussplatinen 17a, die die Messsignale der Dehnmessstreifen-Systeme aufnehmen und über Leitungen an die wenigstens eine Platinenanordnung 13a angeschlossen sind, direkt entsprechend radial außenliegenden Frontseiten der Brückenelemente 4a zugeordnet sind. Die Platinenanordnung 13a umfasst wenigstens eine hochkant ausgerichtete Elektronikplatine, auf der Elektronikkomponenten zur Verstärkung und Verarbeitung der Messsignale der Dehnmessstreifen angeordnet sind. Jede Anschlussplatine 17a ist plattenförmig formstabil ausgeführt und in ihrer Außenkontur auf eine Außenkontur des jeweiligen Brückenelementes 4a abgestimmt. Jede Anschlussplatine 17a weist zudem einen kreisförmigen Durchtritt auf, der zu der zylindrischen Bohrung 8a des jeweiligen Brückenelementes 4a fluchtet. Die jeweilige Anschlussplatine 17a ist mittels jeweils eines mechanischen Befestigungsmittels 14a, vorliegend in Form einer Befestigungsschraube, an einer Befestigungsfläche 6a eines Außenrandes der unteren Anschlussscheibe 3a in hochkanter und zur Frontseite des jeweiligen Brückenelementes 4a paralleler Ausrichtung befestigt.

Dadurch, dass die jeweilige Anschlussplatine 17a direkt im Bereich der Messstellen positioniert ist, ist es möglich, entsprechende Verdrahtungen, die vom jeweiligen Dehnmessstreifen-System im Bereich der konkaven Einbuchtungen 9a und im Bereich der zylindrischen Bohrungen 8a abgehen, mit äußerst kurzem Weg direkt entsprechenden Anschlussstellen der Anschlussplatine 17a zu führen. Entsprechende Anschlussstellen der Anschlussplatine sind jeweils unmittelbar benachbart zu den jeweiligen DMS-System der Bohrung 8a oder der Einbuchtung 9a vorgesehen. Anschlussabgänge jeder Anschlussplatine 17a, die dann Leitungen zu den Elektronikplatinen der Platinenanordnung 13a zugeordnet sind, können im Bereich eines unteren oder oberen Randes der Anschlussplatine 17a aufgereiht nebeneinander positioniert sein, um eine einfach und platzsparende Leitungsanbindung zu ermöglichen.

Im radial innenliegenden Bereich des Kraft-Moment-Sensors 1a ergibt sich durch die hochkante Ausrichtung zusätzlicher Raum. Dadurch wird eine radial innenseitige Durchführung von Kabeln K ermöglicht. Hierzu weist nicht nur die obere Anschlussscheibe 2a, sondern auch die untere Anschlussscheibe 3a einen kreisförmigen Durchtritt auf.

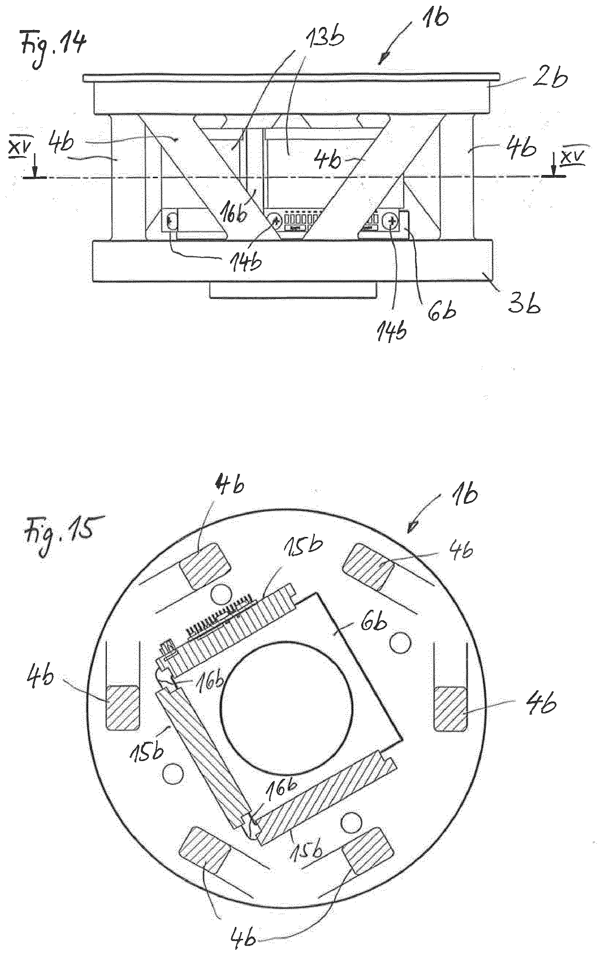

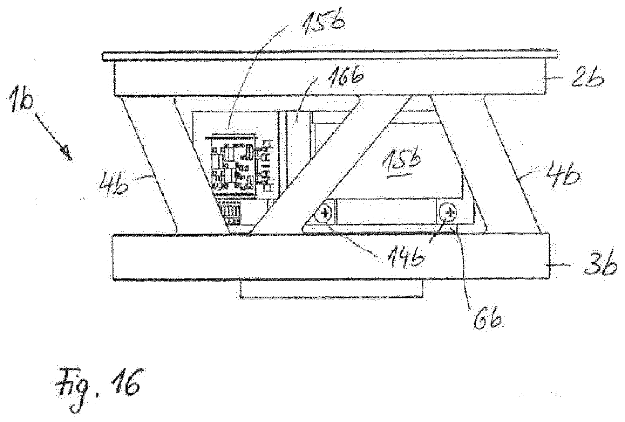

Der Kraft-Moment-Sensor 1b nach den Figuren 14 bis 16 ist nach dem Hexapod-Prinzip gestaltet. Dies bedeutet, dass der Kraft-Moment-Sensor 1b ebenfalls zwei Anschlussscheiben 2b, 3b aufweist, die über schräg erstreckte Hexapod-Streben 4b einstückig miteinander verbunden sind. Auch bei dem Kraft-Moment-Sensor 1b gilt, dass funktionsgleiche Bauteile und Abschnitte mit gleichen Bezugszeichen versehen sind wie bei der Ausführungsform nach den Figuren 1 bis 11, jedoch unter Hinzufügung des Buchstabens b. Die Hexapod-Streben 4b erstrecken sich, wie anhand der Figuren 14 und 16 gut erkennbar ist, jeweils gegensinnig im gleichen Winkel nach oben und nach unten zwischen den Anschlussscheiben 2b, 3b und sind gleichmäßig über den Umfang des Kraft-Moment-Sensors 1b verteilt. Die unteren Anschlussscheibe 3b ist in identischer Weise mit einem Stützblock versehen wie die untere Anschlussscheibe 3 gemäß der Ausführungsform nach den Figuren 1 bis 11. Der Stückblock ragt von einer Oberseite der unteren Anschlussscheibe 3b aus nach oben ab, weist eine quadratische Grundfläche auf und ist im Bereich seines Außenrandes mit rechtwinklig zueinander ausgerichteten, vertikal nach oben ragenden, ebenen Stützflächen 6b versehen, an denen wenigstens eine Platinenanordnung 13b in aufrecht stehender Positionierung gehalten ist. Hierzu sind mechanische Befestigungselemente in Form von Schraubverbindungen 14b vorgesehen, die die Platinenanordnung 13b an den Stützflächen 6b sichern. Der Stützblock ist innenseitig mit einem kreisförmigen Durchtritt versehen, der zu einem kreisförmigen Durchtritt der oberen Anschlussscheibe 2b fluchtet, um eine entsprechende Kabeldurchführung zu ermöglichen (Fig. 15). Die Platinenanordnung 13b weist sowohl mehrere Elektronikplatinen 15b als auch entsprechende flexible Verbindungselemente 16b auf, die Eckverbindungen zwischen jeweils zwei Elektronikplatinen 15b bilden (Fig. 15).

Entsprechende Dehnmessstreifen-Systeme sind im Bereich der Hexapod-Streben 4b in nicht näher dargestellter Weise angebracht. Die Dehnmessstreifen-Systeme sind in analoger Weise über Verdrahtungen, Leitungsführungen und Ähnliches mit Anschlüssen der Platinenanordnung 13b verbunden. Die Anschlüsse können durch Anschlussplatinen gebildet sein, wie sie anhand der Ausführungsform der Figuren 1 bis 11 näher beschrieben wurde.

Alle Ausführungsformen gemäß den Figuren 1 bis 16 weisen im Bereich der beiden Anschlussscheiben zu einer Mittellängsachse des Kraft-Moment-Sensors 1b koaxiale zylindrische Durchtritte auf, die die Hindurchführung von Kabeln zu ermöglichen.

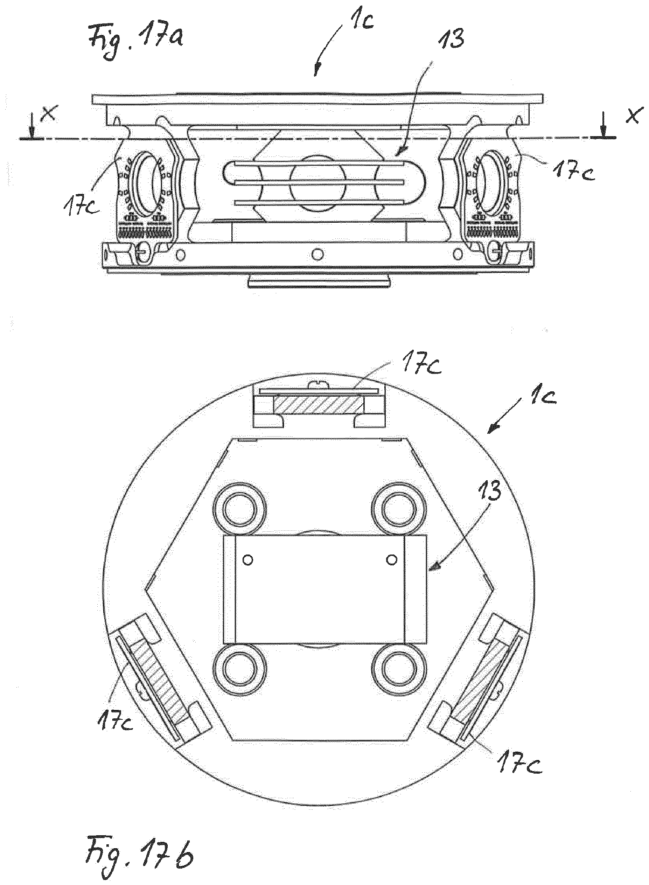

Die Kraft-Moment-Sensoren 1c bis 1e gemäß den Fig. 17a, 17b, 18a, 18b, 19a und 19b entsprechen im Wesentlichen der zuvor anhand der Fig. 1 bis 11 beschriebenen Ausführungsform eines Kraft-Moment-Sensors 1 mit dem Unterschied, dass entsprechende Anschlussplatinen 17c, 17d und 17e jeweils frontseitig direkt an entsprechenden Brückenelementen positioniert sind, wie dies bei der Ausführungsform nach den Fig. 12 und 13 der Fall ist. Zur Vermeidung von Wiederholungen wird daher bezüglich entsprechender Funktionsabschnitte und Funktionsteile auf die zuvor erfolgten Beschreibungen der Ausführungsformen gemäß den Fig. 1 bis 13 verwiesen. Nachfolgend wird auf die Unterschiede der Kraft-Moment-Sensoren 1c bis 1e relativ zu den Kraft-Moment-Sensoren 1 und 1a gemäß den Fig. 1 bis 13 eingegangen.

Bei allen drei Kraft-Moment-Sensoren 1c bis 1e sind formstabile Anschlussplatinen 17c bis 17e unmittelbar benachbart zu entsprechenden Dehnmessstreifen-Systemen der Brückenelemente der Kraft-Moment-Sensoren 1c bis 1e angeordnet. Jeder der Kraft-Moment-Sensoren 1c bis 1e weist eine Platinenanordnung 13 auf, wie sie anhand der Fig. 11 dargestellt ist. Die jeweilige Platinenanordnung 13 besteht aus drei Elektronikplatinen 15 sowie aus zwei flexiblen Verbindungselementen 16, in denen entsprechende Leitungen integriert sind. Wesentlicher Unterschied zu den Ausführungsformen nach den Fig. 1 bis 13 ist es, dass die Platinenanordnung 13 bei den Kraft-Moment-Sensoren 1c bis 1e jeweils in kompakt zusammengefaltetem Zustand am Kraft-Moment-Sensor 1c bis 1e positioniert und befestigt ist. Bei der Ausführungsform des Kraft-Moment-Sensors 1c gemäß den Fig. 17a und 17b ist die Platinenanordnung 13 in liegender Ausrichtung positioniert und gesichert. Entsprechende Verdrahtungen zu den drei Anschlussplatinen 17c, die entsprechende Verbindungsleitungen bilden, sind nicht dargestellt.

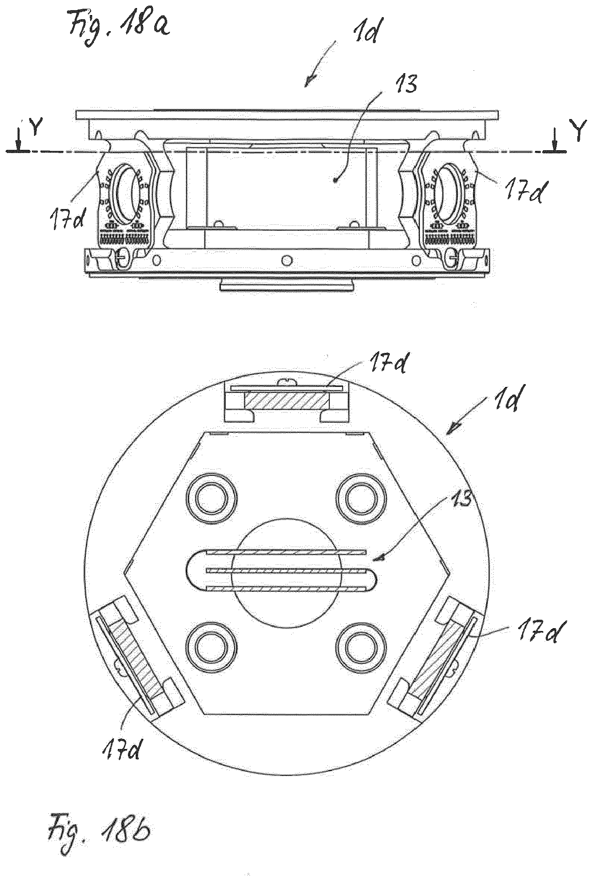

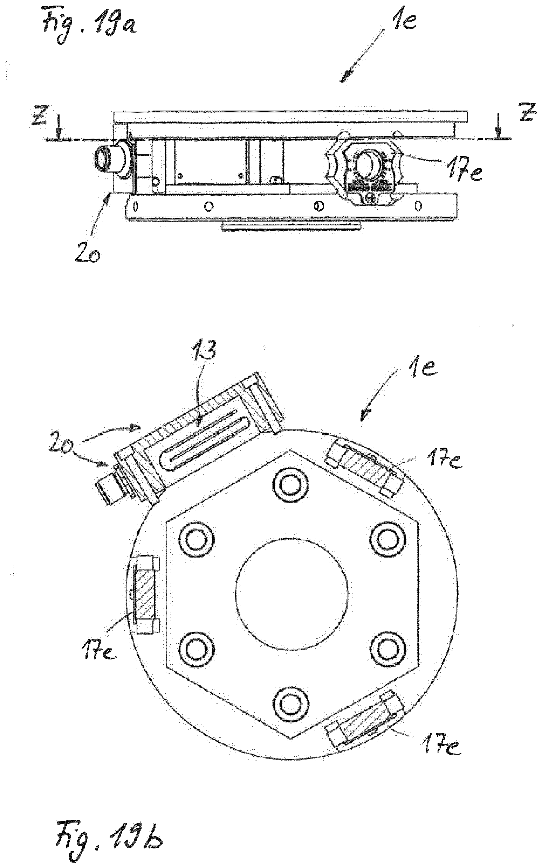

Bei der Ausführungsform gemäß den Fig. 18a und 18b ist die Platinenanordnung 13 in aufrecht stehender, aber parallel zusammengefalteter Ausrichtung zwischen den einander zugewandten Innenseiten der beiden Anschlussscheiben des Kraft-Moment-Sensors 1d positioniert und in dieser Ausrichtung fixiert. Bei dem Kraft-Moment-Sensor 1e gemäß den Fig. 19a und 19b ist die Platinenanordnung 13 aus dem Inneren des Kraft-Moment-Sensors 1e ausgelagert. Dabei ist die Platinenanordnung 13 in kompakter, parallel zusammengefalteter Ausrichtung in einem Aufnahmeraum eines Steckverbindungsteiles 20 positioniert und gesichert, das an einem Umfang des Kraft-Moment-Sensors 1e angeflanscht ist. Das Steckverbindungsteil 20 weist einen Steckerabgang auf und ist einschließlich eines den Aufnahmeraum für die Platinenanordnung 13 umgebenden Gehäuses durch Schraubverbindungen lösbar mit einer Außenkontur des Kraft-Moment-Sensors 1e verbunden.

Sowohl bei dem Kraft-Moment-Sensor 1d als auch bei dem Kraft-Moment-Sensor 1e sind die entsprechenden Anschlussplatinen 17d, 17e über entsprechende Leitungen, insbesondere durch Verdrahtungen, mit der Platinenanordnung 13 verbunden. Bei dem Kraft-Moment-Sensor 1e sind entsprechende Leitungsabgänge der Platinenanordnung 13 mit dem Steckerabgang elektrisch leitend verbunden. Bei den anderen Kraft-Moment-Sensoren 1c und 1d sind entsprechende Steckerabgänge und entsprechende Leitungsverbindungen zwischen den Steckerabgängen und der jeweiligen Platinenanordnung 13 vorgesehen, aber nicht dargestellt.

## Patentansprüche

1. Kraft-Moment-Sensor zur Erfassung von Kräften und Momenten bei einer Robotikeinheit mit einem einteiligen Trägerkörper (1, 1a), der eine zylindrische Grundform aufweist und mit zwei zueinander parallelen Anschlussscheiben (2, 3; 2a, 3a) sowie wenigstens drei die Anschlussscheiben (2, 3; 2a, 3a) miteinander verbindenden Brückenelementen (4, 4a) versehen ist, denen jeweils wenigstens eine Messstelle zugeordnet ist, **dadurch gekennzeichnet, dass** der Trägerkörper (1, 1b) im Bereich wenigstens einer Anschlussscheibe (2, 3; 2b, 3b) auf einer der anderen Anschlussscheibe (2, 3; 2b, 3b) zugewandten Innenseite mit einer Stützanordnung (5a, 5b; 6b) versehen ist, an der wenigstens eine mit Elektronikkomponenten versehene Platinenanordnung (13, 13b) hochkant ausgerichtet fixiert ist, derart, dass die Platinenanordnung (13, 13b) orthogonal zu den entsprechenden Stirnflächen der Anschlussscheiben (2, 3; 2b, 3b) angeordnet ist.

2. Kraft-Moment-Sensor nach Anspruch 1, **dadurch gekennzeichnet, dass** jedes Brückenelement (4, 4a) eine zentrale zylindrische Bohrung (8, 8a) als Messstelle aufweist, und dass jedes Brückenelement (4, 4a) an seinen gegenüberliegenden Außenrändern mit jeweils einer konkaven Einbuchtung (9, 9a) versehen ist, an der jeweils eine weitere Messstelle vorgesehen ist.

3. Kraft-Moment-Sensor nach Anspruch 2, **dadurch gekennzeichnet, dass** jede konkave Einbuchtung (9, 9a) teilzylindrisch gestaltet ist, wobei alle Einbuchtungen (9, 9a) jeweils den gleichen Radius aufweisen.

4. Kraft-Moment-Sensor nach einem der vorhergehenden Ansprüche, **dadurch gekennzeichnet, dass** die Platinenanordnung (13, 13b) in ihrer Höhe auf einen Abstand von Innenseiten der Anschlussscheiben (2, 3; 2b, 3b) des Trägerkörpers (1, 1b) abgestimmt ist.

5. Kraft-Moment-Sensor nach Anspruch 1, **dadurch gekennzeichnet, dass** die Brückenelemente (4b) als Hexapod-Streben gestaltet sind.

6. Kraft-Moment-Sensor nach einem der vorhergehenden Ansprüche, **dadurch gekennzeichnet, dass** an den Messstellen Dehnmessstreifen (D) vorgesehen sind, die jeweils in vorgefertigter Anordnung und Gruppierung auf einer Trägerfolie (T) gehalten sind, die im Bereich der Messstellen mit dem jeweiligen Brückenelement (4) verklebt ist.

7. Kraft-Moment-Sensor nach einem der vorhergehenden Ansprüche, **dadurch gekennzeichnet, dass** die Platinenanordnung (13, 13b) wenigstens eine Elektronikplatine (15, 15b), auf der Elektronikkomponenten angeordnet sind, sowie mit wenigstens eine Anschlussplatine (17), die mit der wenigstens einen Elektronikplatine (15) über Leitungen verbunden ist, aufweist, wobei wenigstens zwei Elektronikplatinen (15, 15b) miteinander und/oder wenigstens eine Anschlussplatine (17) mit wenigstens einer Elektronikplatine (15, 15b) über wenigstens ein flexibles Verbindungselement (16, 18; 16b) verbunden sind, in dem die Leitungen integriert sind.

8. Kraft-Moment-Sensor nach Anspruch 7, **dadurch gekennzeichnet, dass** das wenigstens eine flexible Verbindungselement (16, 18; 16b) sich durchgängig über eine gesamte Höhe einer benachbarten Elektronikplatine (15, 15b) erstreckt.

9. Kraft-Moment-Sensor nach Anspruch 7, **dadurch gekennzeichnet, dass** das wenigstens eine flexible Verbindungelement (18) sich durchgängig längs eines Seitenrands einer Anschlussplatine (17) erstreckt.

10. Kraft-Moment-Sensor nach Anspruch 7, **dadurch gekennzeichnet, dass** das flexible Verbindungselement (16, 18) derart biegbar ist, dass die Elektronikplatinen (15) und/oder die wenigstens eine Anschlussplatine (17) einander parallel überlagernd zusammenfaltbar sind.

## Claims

1. Force-momentum sensor for detecting forces and momentums with a robotics unit, comprising a one-piece carrier body (1, 1a), which has a cylindrical basic shape and is provided with two mutually parallel connecting disks (2, 3; 2a, 3a) and at least three bridge elements (4, 4a) interconnecting the connecting disks (2, 3; 2a, 3a), with each bridge element having at least one measuring point assigned thereto,
**characterized in that**
the carrier body (1, 1b), in the vicinity of at least one connecting disk (2, 3; 2b, 3b), is provided with a support block (5a, 5b; 6b) on an interior side facing the other connecting disk (2, 3; 2b, 3b), to which support block at least one circuit board structure (13, 13b) provided with electronic components is fixed in an on-edge orientation such that the circuit board structure (13, 13b) is disposed orthogonal to the corresponding end faces of the connecting disks (2, 3; 2b, 3b).

2. Force-momentum sensor according to claim 1, **characterized in that** each bridge element (4, 4a) has a central cylindrical hole (8, 8a) as a measuring point, and **in that** each bridge element (4, 4a) is provided on its opposite outer edges with a respective concave recess (9, 9a), and on each recess a further measuring point is provided.

3. Force-momentum sensor according to claim 2, **characterized in that** each concave recess (9, 9a) has a partially cylindrical design, wherein all recesses (9, 9a) respectively have the same radius.

4. Force-momentum sensor according to any of the preceding claims, **characterized in that** the circuit board structure (13, 13b) is matched in height to a distance of interior sides of the connecting disks (2, 3; 2b, 3b) of the carrier body (1, 1b).

5. Force-momentum sensor according to claim 1, **characterized in that** the bridge elements (4b) have a hexapod web design.

6. Force-momentum sensor according to any of the preceding claims, **characterized in that** strain gauges (D) are provided on the measuring points, each strain gauge retained on a carrier film (T) in a pre-fabricated arrangement and grouping, with said film adhesively bonded to the respective bridge element (4) in the vicinity of the measuring points.

7. Force-momentum sensor according to any of the preceding claims, **characterized in that** the circuit board structure (13, 13b) comprises at least one electronic board (15, 15b) with electronic components disposed thereon, and at least one connection board (17) connected to the at least one electronic board (15) via lines, wherein at least two electronic boards (15, 15b) are connected to each other and/or at least one connection board (17) is connected to at least one electronic board (15, 15b) via at least one flexible connector element (16, 18; 16b) in which the lines are integrated.

8. Force-momentum sensor according to claim 7, **characterized in that** the at least one flexible connector element (16, 18; 16b) extends continuously over an entire height of an adjacent electronic board (15, 15b).

9. Force-momentum sensor according to claim 7, **characterized in that** the at least one flexible connector element (18) extends continuously along a lateral edge of a connection board (17).

10. Force-momentum sensor according to claim 7, **characterized in that** the flexible connector element (16, 18) is bendable such that the electronic boards (15) and/or the at least one connection board (17) are foldable, overlapping each other in parallel.

## Revendications

1. Capteur de force-couple pour détecter forces et moments dans une unité robotique, comprenant un corps porteur (1, 1a) monobloc, présentant une forme de base cylindrique et étant pourvu de deux disques de raccordement (2, 3 ; 2a, 3a) parallèles entre eux ainsi qu'au moins trois éléments de pont (4, 4a) connectant les disques de raccordement (2, 3 ; 2a, 3a) l'un à l'autre, chacun des éléments de pont associé à au moins un point de mesure,
**caractérisé en ce que**
le corps porteur (1, 1b), à proximité d'au moins un disque de raccordement (2, 3 ; 2b, 3b), est pourvu d'un arrangement de support (5a, 5b ; 6b) sur un côté intérieur faisant face à l'autre disque de raccordement (2, 3 ; 2b, 3b), sur l'arrangement de support au moins un arrangement de circuits imprimés (13, 13b) pourvu de composants électroniques est fixé en étant posé sur le chant de telle manière que l'arrangement de circuits imprimés (13, 13b) est disposé orthogonalement par rapport aux faces frontales correspondantes des disques de raccordement (2, 3 ; 2b, 3b).

2. Capteur de force-couple selon la revendication 1, **caractérisé en ce que** chacun des éléments de pont (4, 4a) présente un trou cylindrique central (8, 8a) en tant que point de mesure, et **en ce que** chacun des éléments de pont (4, 4a) est pourvu d'un renfoncement (9, 9a) concave respectif sur ses bords extérieurs opposés, un autre point de mesure étant pourvu sur chaque renfoncement.

3. Capteur de force-couple selon la revendication 2, **caractérisé en ce que** chaque renfoncement (9, 9a) concave est conçu sous forme partiellement cylindrique, dans lequel tous les renfoncements (9, 9a) présentent le même radius.

4. Capteur de force-couple selon l'une quelconque des revendications précédentes, **caractérisé en ce que** la hauteur de l'arrangement de circuits imprimés (13, 13b) est adaptée à une distance de côtés intérieurs des disques de raccordement (2, 3 ; 2b, 3b) du corps porteur (1, 1b).

5. Capteur de force-couple selon la revendication 1, **caractérisé en ce que** les éléments de pont (4b) sont conçus sous forme d'entretoises hexapodes.

6. Capteur de force-couple selon l'une quelconque des revendications précédentes, **caractérisé en ce que** des jauges de contrainte (D) sont prévues sur les points de mesure, chacune des jauges retenue sur une feuille porteuse (T) dans un arrangement et groupement préfabriqué, la feuille étant collée à l'élément de pont (4) respectif à proximité des points de mesure.

7. Capteur de force-couple selon l'une quelconque des revendications précédentes, **caractérisé en ce que** l'arrangement de circuits imprimés (13, 13b) comporte au moins un circuit électronique (15, 15b), présentant des composants électroniques disposés au-dessus, et au moins un circuit de raccordement (17), connecté à l'au moins un circuit électronique (15) par des lignes, dans lequel au moins deux circuits électroniques (15, 15b) sont reliés l'un à l'autre et/ou au moins un circuit de raccordement (17) est relié à au moins un circuit électronique (15, 15b) par au moins un élément connecteur (16, 18 ; 16b) flexible où les lignes sont intégrées.

8. Capteur de force-couple selon la revendication 7, **caractérisé en ce que** l'au moins un élément connecteur (16, 18 ; 16b) flexible s'étend constamment à travers une hauteur totale d'un circuit électronique (15, 15b) adjacent.

9. Capteur de force-couple selon la revendication 7, **caractérisé en ce que** l'au moins un élément connecteur (18) flexible s'étend constamment le long d'un bord latéral d'un circuit de raccordement (17).

10. Capteur de force-couple selon la revendication 7, **caractérisé en ce que** l'élément connecteur (16, 18) flexible est pliable de telle manière que les circuits électroniques (15) et/ou l'au moins un circuit de raccordement (17) sont repliables, se chevauchant en parallèle.
